# EUROPÄISCHE PATENTSCHRIFT

(11) **EP 0 417 750 B1**
(45) Veröffentlichungstag und Bekanntmachung des Hinweises auf die Patenterteilung: **13.11.1996**
(21) Anmeldenummer: 90117529.9
(22) Anmeldetag: 12.09.1990
(51) Int. Cl.: H05K 3/10, H05K 3/42, C25D 5/56

(54) **Verfahren zur direkten Metallisierung von Leiterplatten**
Process for direct metallization of circuit boards
Procédé de metallisation directe de plaques à circuits

(30) Priorität: 14.09.1989 DE 3931003; 05.12.1989 DE 3940565
(43) Veröffentlichungstag der Anmeldung: 20.03.1991
(73) Patentinhaber: ATOTECH Deutschland GmbH, 10553 Berlin (DE)
(72) Erfinder: Bressel, Burkhard, Dr., D-1000 Berlin 19 (DE); Meyer, Heinrich, Dr.Dr., D-1000 Berlin 39 (DE); Meyer, Walter, D-1000 Berlin 28 (DE); Gedrat, Klaus, D-1000 Berlin 28 (DE)
(74) Vertreter: Effert, Udo, Dipl.-Ing.

(56) Entgegenhaltungen:
- EP-A- 0 206 133
- WO-A-89/08375
- PATENT ABSTRACTS OF JAPAN, Bd. 12, Nr. 373 (C-534)(3220) 6 Oktober 1988; & JP-A- 63 125696
- ELECTRONIC PACKAGING AND PRODUCTION. vol. 28, no. 8, August 1988, Newton, Massachusett, Seiten 40-43, DUDIK: "A system approach to drilled-hole cleaning"

## Beschreibung

Die Erfindung betrifft ein Verfahren zur direkten Metallisierung von Leiterplatten in einer horizontal arbeitenden Durchlaufanlage, unter Auslassung außenstromloser Elektrolyte.

Bei der Bohrlochmetallisierung von Leiterplatten werden überwiegend außenstromlose Kupferelektrolyte zur Erzeugung dünner elektrisch leitender Schichten auf den isolierenden Flächen eingesetzt, die anschließend durch galvanische Cu-Abscheidung auf die gewünschte Schichtdicke verstärkt werden.

Neben einer Reihe von Vorteilen, wie gleichmäßige Schichtdicke und guter Haftung sowohl auf dem nichtleitenden Basismaterial als auch auf den Kupferinnenlagen und der Kupferdeckfolie gibt es auch eine Reihe von Nachteilen:
Das Verfahren ist aufwendig, denn die Bohrlochwandung muß zunächst nach der Reinigung durch Edelmetallkeime katalytisch aktiviert werden. Außerdem ist zum störungsfreien Betrieb der stromlosen Bäder ein hoher Überwachungsaufwand nötig, sie enthalten meist Formaldehyd, das gesundheitschädlich ist und die Entsorgung dieser Bäder ist wegen des Komplexbildnergehaltes problematisch.

Wegen dieser Nachteile hat es nicht an Versuchen gefehlt, die außenstromlose Bohrlochmetallisierung zu ersetzen. Der Ersatz bedeutet in jedem Fall aber das Erzeugen einer elektronenleitenden Zwischenschicht auf dem isolierenden Basismaterial, auf der dann das zur Durchkontaktierung erforderliche Kupfer elektrolytisch abgeschieden werden kann. Nach dem Stand der Technik werden derzeit für solche Zwischenschichten Kohlenstoffpartikel und - schichten aus edelmetallhaltigen Mischoxiden oder Hydroxiden, z. B. Sn-stabilisierte Pd-Kolloide verwendet. Außerdem wird über leitfähige Polymere berichtet, durch die auf nichtleitenden Oberflächen Elektronenleitung erzeugt werden kann.

Aus WO-A-89 08 375 ist ein Metallisierungsverfahren bekannt, bei welchem die Substratoberfläche zunnächst mit einer oxidierenden Lösung vorbehandelt, gespült, und dann in eine Lösung eines zur Bildung leitfähiger Polymere geeingneten Monomers eingetancht wird, woraufhin in saurer Lösung polymerisiert und anschließend galvanish oder außenstromlos metallisiert wird. Das Verfahren wird in Tauchbadanlagen durchgeführt.

Die europäische Anmeldung Nr. 0206133 vom 11. 6. 1986 beschreibt leitende Oberflächenfilme vom Polypyrroltyp, die europäische Anmeldung Nr. 0152632 vom 28. 12. 1984 beschreibt poröse leitfähige Überzüge vom Chinondiimin-Typ. In der deutschen Offenlegungsschrift 3321281 wird ein Verfahren zur Erhöhung der Leitfähigkeit imprägnierbarer Materialien beschrieben, das leitfähige System ist hier oxidiertes Polypyrrol.

Die nach dem Stand der Technik erzeugten elektronenleitenden Zwischenschichten müssen jedoch zusätzliche Anforderungen erfüllen, bevor sie zur Durchkontaktierung von Leiterplatten eingesetzt werden können.
1. Es muß ein stabiler Haftverbund zwischen dem Basismaterial (vorzugsweise glasfaserverstärktes Epoxid) und der galvanisch abgeschiedenen Metallschicht, vorzugsweise Kupfer, entstehen.
2. Durch Aufbringen der Zwischenschicht darf keine Beeinträchtigung der Haftung der galvanisch abgeschiedenen Metallschicht auf schon vorhandenen kupferflächen erfolgen.

Alle bisher bekannt gewordenen nichtmetallischen Leitschichten, die stromlos abgeschiedenes Kupfer ersetzen sollen, können die Forderung 2. nicht erfüllen, das heißt, die elektronenleitenden Zwischenschichten müssen selektiv vom metallischen Kupfer restlos entfernt werden. Selbst geringe Rückstände von Edelmetallkeimen, die auf der Cu-Schicht adsorbiert sind, führen zu einer starken Beeinträchtigung des Gefüges von anschließend aufgebrachten, elektrolytischen Metall- beziehungsweise Cu-Schichten, zumindest im Grenzschichtbereich.

Diese Notwendigkeit einer selektiven Entfernung der leitfähigen Zwischenschichten stellt einen gravierenden Verfahrensnachteil dar, denn das selektive Ablösen erfordert die perfekte Beherrschung von schwierigen Ätzvorgängen, denn sonst besteht die Gefahr, daß die Zwischenschicht auch an den erwünschten Stellen ebenfalls angegriffen, beschädigt oder davon sogar entfernt wird.

Aufgabe der Erfindung ist es daher, sowohl die Verfahrensschritte der katalytischen Aktivierung der Bohrlöcher als auch die stromlose Beschichtung derselben mit dem außenstromlosen Cu-Elektrolyten zu eliminieren und darüber hinaus zu gewährleisten, daß das elektronenleitende Polymer selektiv nur auf den isolierenden Flächen, nicht aber dem Metall abgeschieden wird.

Diese Aufgabe wird erfindungsgemäß durch ein Verfahren mit den Merkmalen des Patentanspruchs 1 gelöst.

Weitere Ausgestaltungen der Erfindung sind den Unteransprüchen zu entnehmen.

Nach dem erfindungsgemäßen Verfahren lassen sich also die Nachteile der bekannten Metallisierungsverfahren bei der Leiterplattenherstellung vermeiden.

Ein weiterer Vorteil des erfindungsgemäßen Verfahrens besteht darin, daß die zur Haftvermittlung und oxidativen Polymerisation verwendete Schicht im Zuge der Permanganat-Bohrlochreinigung ohnehin entsteht, so daß auf einen weiteren Verfahrensschritt, das heißt auf die Entfernung von Braunstein zusätzlich verzichtet werden kann.

Grundsätzlich sind natürlich auch andere oxidische Haftschichten einsetzbar, die in der Lage sind, Oxidationsmittel in ausreichendem Umfang zu adsorbieren.

### Verfahrensbeschreibung 1

1. Nach dem erfindungsgemäßen Verfahren wird der an sich bekannte Permanganat-Desmear-Prozeß dazu benutzt, um eine multifunktionelle Adsorptionsschicht selektiv auf den nichtmetallischen en Oberflächen von Leiterplatten, insbesondere von Bohrlöchern, zu erzeugen.
   Die Mehrfachfunktion der Adsorptionsschicht ist durch folgende Eigenschaften gekennzeichnet:
   a) Hydrophilisierung und Erhöhung der Benetzbarkeit der Oberfläche durch polare Moleküle, insbesondere Wasser.
   b) Oxidationsmittel in einem nachfolgenden Verfahrensschritt.
   c) Benetzbarkeit für das Monomere, aus dem das leitfähige Polymer gebildet wird.

Die Erzeugung der multifunktionellen Adsorptionsschicht kann in besonders einfacher Weise durch den an sich bekannten Permanganatprozeß zur Bohrlochreinigung erfolgen, der aber durch folgende erfindungsgemäße Veränderung gekennzeichnet ist:
1. Die bei der Bohrlochreinigung gebildeten unlöslichen Mangan (IV)-Verbindungen werden nicht entfernt.
2. Nach dem Spülen wird mit Pyrrol oder einer anderen monomeren Vorstufe eines leitfähigen Polymers (zum Beispiel ein anderer 5-Ring-Heterocyclus oder Anilin), das vorzugsweise in einem organischen Lösungsmittel gelöst ist, behandelt. Auch wässrige Lösungen organischer Lösungsmittel, die das Monomer enthalten, können verwendet werden.
   Eine Variante des erfindungsgemäßen Verfahrens besteht darin, gasförmiges Monomer einzusetzen.
   Als Oxidationsmittel wirken die Mangan(IV)-Verbindungen der multifunktionalen Schicht und gegebenenfalls in den Poren noch zurückgebliebene Reste des Permanganations.
3. Der Transport innerhalb weniger 1 bis zu 10 Sekunden (typischerweise 5 - 10 s) zum nächsten Aktivbad wird durch die Horizontaltechnik ermöglicht. Die, die Mangan(IV)-Schicht benetzende Monomerlösung hat dadurch keine Zeit, aus den Bohrungen zu fließen bzw. im unteren Teil der Bohrungen zusammenzulaufen.
   Zusätzlich wird ein Abfließen durch die bei waagerechter Arbeitsweise horizontal verlaufenden Bohrriefen erschwert.
   Dadurch werden im späteren Verfahrensschritt gut leitende Polymere erhalten, die schließlich zu einer fehlerfreien Metallisierung führen.
   Bei Verwendung einer konventionellen Vertikalanlage würde das nachfolgende Aktivbad nicht schnell genug erreicht, und die Monomerlösung würde im unteren Bereich der Bohrungen zusammenfließen. Dadurch wäre im oberen Teil zu wenig Monomer vorhanden und im unteren zu viel.
   Es würden im späteren Verfahrensschritt nur schlecht leitende Polymerschichten gebildet, die schließlich zu einer mangelhaften Metallisierung führen würden.
4. Die vollständige Polymerisation geschieht erfindungsgemäß durch Behandeln der mit Mangan(IV)-Verbindungen belegten und mit Monomer benetzten Oberfläche mit Säure, vorzugsweise mit Schwefelsäure.
   Die Behandlung mit Säure hat aber zusätzliche Aufgaben. Es wird überschüssiges unreagiertes oder nur teilweise reagiertes Pyrrol wirkungsvoll entfernt. Gleichzeitig wirken Mn(IV)-Verbindungen in saurer Lösung als Oxidationsmittel und dienen somit zusammen mit den H⁺-Ionen der Säure der vollständigen Überführung der Polymerschicht in den elektronenleitenden Zustand.
5. Anschließend kann direkt mit einem elektrolytisch abscheidbaren Metall, vorzugsweise aus einem sauren Cu-Elektrolyten Kupfer bis zur gewünschten Endschichtdicke verstärkt werden.

Die technische Realisierung benötigt für den Verfahrensschritt 3.kurze und wohl definierte Transportzeiten. Dieses läßt sich im horizontalen Durchlaufverfahren erreichen.

Weiterer Vorteil der Horizontaltechnik:
Keine Pyrrolkontaminationen der Umgebung. Dies ist besonders wichtig, weil die monomeren Vorstufen einen relativ hohen Dampfdruck aufweisen.

### Verfahrensbeschreibung 2

1. Nach dem erfindungsgemäßen Verfahren werden an sich bekannte Verfahren benutzt, um durch Quellen, Aufrauhen ect. eine multifunktionale Adsorptionsschicht selektiv auf den nichtmetallischen Oberflächen von Leiterplatten, insbesondere von Bohrlöchern, zu erzeugen.
   Die Mehrfachfunktion der Adsorptionsschicht ist durch folgende Eigenschaften gekennzeichnet:
   a) Hydrophilisierung und Erhöhung der Benetzbarkeit der Oberfläche durch polare Moleküle, insbesondere Wasser.
   b) Adsorption von Oxidationsmittel beziehungsweise Einschluß desselben in ausreichender Menge, das in einem nachfolgenden Verfahrensschritt benötigt wird.
   c) Adsorption des Monomeren, aus dem das leitfähige Polymer gebildet wird.
2. Die Erzeugung der multifunktionellen Adsorptionsschicht kann in besonders einfacher Weise, durch an sich bekannte Verfahren, wie z. B. Quellen in organischen Lösungsmitteln oder mikroporöse Aufrauhung durch z. B. Chromschwefelsäure, erfolgen.
   a) Nach dem Spülen wird die Leiterplatte mit der Oxidationslösung in Kontakt gebracht.
   b) Der dem Oxidationsprozeß nachgeschaltete Spülvorgang wird mittels Horizontaltechnik sehr kurz (1 - 10 sec) gehalten, um das in der Adsorptionsschicht adsorbierte, beziehungsweise in den Poren vorhandene Oxidationsmittel, nicht auszulaugen, andererseits aber überschüssiges, insbesondere auf den Metallflächen anhaftendes Oxidationsmittel zu entfernen.

Die technische Realisierung des Verfahrens benötigt für die Verfahrensschritte 1. und 2. kurze und wohldefinierte Reaktionszeiten. Dieses läßt sich besonders geeignet in horizontalen Durchlaufverfahren mit Zwangsdurchflutung der Bohrlöcher (Schwallen, Saugen, Sprühen) und Kombinationen erreichen.
a) Weitere Vorteile der Horizontaltechnik:
   Keine Pyrrolkontaminationen der Umgebung, besonders wichtig, weil die monomeren Vorstufen einen relativ hohen Dampfdruck aufweisen.
b) Kompaktbauweise der Anlagenmodule durch kurze Verweildauer (kostengünstige Lösung).

Horizontale Durchlaufanlagen für die Metallisierung von Leiterplatten der bekannten Technik werden durch die Aneinanderreihung verschiedener Behandlungsmodule hergestellt.

Die Einzelmodule werden mit den für die Prozeßfolge notwendigen Chemikalien und/oder Spülbädern beschickt. Solche Anlagen für den konventionellen Prozess sind beispielweise 25 m lang und mit einem sehr aufwendigen Transportsystem ausgestattet und benötigen einen erheblichen Raumbedarf. Die Länge derartiger Anlagen wird durch die Behandlungsdauer beim Durchlauf von Leiterplattensubstraten bestimmt, die dem Metallisierungsprozeß angepaßt sein müssen.

So ergibt sich beispielsweise eine Anlagenlänge nach dem heutigen Stand der Technik von minimal 25 m, die im wesentlichen nach dem derzeitigen Kenntnisstand durch Prozeßchemikalien bedingt sind, die durch ihre Sauerstoffempfindlichkeit nicht nur unmständlich, sondern auch nur sehr kostenaufwendig in derartigen Anlagen eingesetzt werden können; geschweige denn von ihrer hohen Umweltbelastung. Außerdem erfordert dieser Prozeß eine sehr exakte Überwachung und Kontrolle.
Derartige Anlagen haben, wie bereits erwähnt, einen Platzbedarf von etwa 25 m, bei einer Bearbeitungskapazität von 25 m²/Std. Der Wartungsaufwand derartiger Anlagen ist relativ groß. Es bestand darum die Notwendigkeit, eine wirtschaftlich und technisch vertretbare Verkürzung solcher horizontaler Durchlaufanlagen und Fertigungsprozesse anzustreben.

Eine in der EP-Anmeldung 0 206 133 aufgeführte Methode zur Metallisierung von Kunstoffen erwies sich nach flüchtiger Betrachtung und im Laborbetrieb zunächst als sehr brauchbar. Die Übertragung der Herstellungsmethode auf die bekannte vertikale Großanlage erwies sich jedoch als nicht durchführbar, da die an die oben genannte Methode gebundenen kurzen, prozeßrelevanten Behandlungs- bzw. Transportzeiten durch die sehr aufwendigen und schwer zu handhabenden Beschickungsmechaniken (Warenträger) nicht erzielt werden konnten.

So sind z. B. Behandlungs- und Transportzeiten von etwa 10 sec. Dauer für eine sichere Prozeßführung notwendig. Um dieses zu erreichen, wurde die Technik einer Hochgeschwindigkeitsbenetzungseinrichtung, bestehend aus einer stehenden Welle oder Schwalldüsen vorgeschlagen, die die erwünschte, notwendige verkürzte Benetzung in einer horizontalen Durchlaufanlage ermöglicht. Derartige Hochgeschwindigkeitsanlagen ind er Horizontaltechnik sind z. B. in ähnlicher Form aus dem Bereich der Lackauftragungstechnik hinreichend bekannt.

Durch die Anwendung dieses Verfahrens verkürzt sich die Länge einer horizontalen Durchlaufanlage um etwa 15 m. Dadurch ergibt sich eine seit Jahren gewünschte Möglichkeit, eine Permanganatvorbehandlungslinie der Metallisierungseinrichtung vorzuschalten, die eine Verknüpfung der Prozeßschritte in üblicher Weise ermöglicht. Dies ist besonders günstig, da die Permanganatbehandlung nicht nur der Bohrlochreinigung dient, sondern auch als notwendige Vorstufe für den sich anschließenden Metallisierungsprozeß zu sehen ist.

Das Verfahren beschränkt sich jedoch nicht nur auf die Erzeugung leitender Schichten in Bohrlöchern, es kann seblstverständlich auch zur Metallisierung von isolierenden Oberflächen beliebiger Geometrie verwendet werden, d. h. auch zur Flächenmetallisierung und zur Erzeugung von Leiterzügen. Es gewährleistet nicht nur eine gute Haftung des galvanisch abgeschiedenen Kupfers auf dem organischen Substratmaterial, sondern auch auf der Glasfaser.

Darüber hinaus können zur galvanischen Verstärkung auch andere für die technische Anwendung geeignete Metalle, wie Nickel, Zinn, Zinn/Blei-Legierung oder Gold verwendet werden. Neben den hauptsächlich verwendeten Epoxid-Leiterplatten (FR 4) können natürlich auch andere Leiterplatten sowie Multilayer, die aus verschiedenen faserverstärkten und nicht faserverstärkten Polymeren bestehen und auch solche mit metallischen Innenlagen verarbeitet werden. Solche Materialien sind Polyimid, Polyetherimid, Polyethersulfon usw.

Die folgenden Beispiele dienen der Erläuterung der Erfindung.

### Beispiel 1 (Durchmetallisierung in horizontaler Durchlaufanlage)

- 1.0: 1 min ätzen in Persulfat-Schwefelsäure (80 g/l H₂SO₄, 120 g/l Na-Persulfat), RT, Sprühdüsen
- 1.1: Transport, ca. 10 s
- 2.0: 1 min Schwallspülung
- 2.1: Transport, ca. 10 s
- 3.0: 2 min Queller (Vorschub 0,7 m/min; Modullänge 1,40 m), 70° C, Schwalldüse, Ultraschall-unterstützt.
- 3.1: Transport, ca. 10 s
- 4.0: 1 min Schwallspülung
- 4.1: Transport, ca. 10 s
- 5.0: 2 min KMnO₄-Behandlung (Vorschub 0,7 m/min; Modullänge 1,40 m. Elektrolytzusammensetzung 60 g/l KMnO₄, 60 g/l NaOH, 70° C, Schwalldüsen
- 5.1: Transport, ca. 10 s
- 6.0: 1 min Schwallspülen
- 6.1: Transport, ca. 10 s
- 7.0: 20 s Aktivierung (Vorschub 0,7 m/min, Modullänge 35 cm, Elektrolyt: 10 % Pyrrol, 30 % N-Methylpyrrolidon, Rest Wasser), RT, stehende Welle
- 7.1: Transport 5 - 10 s (Transportweg ca. 10 cm vom Aktivator zum nächsten Bad, Vorschub 0,7 m/min).
- 8.0: 30 s Säurebehandlung (Vorschub 0,7 m/min, Modullänge 35 cm, Elektrolyt 300 - 350 g/l H₂SO₄).
- 8.1: Transportzeit, ca. 10 s
- 9.0: 1 min Schwallspülung
- 9.1: Transport, ca. 20 s
- 10.0: 1 min Dekapierung (180 g/l H₂SO₄), RT, stehende Welle
- 10.1: Transport, ca. 10 s
- 11.0: 5 m Anschlagsverkupferung (Elektrolysezeit 2 min, 30 s, 10 A/dm²), RT
- 11.1: Trocknung, ca. 1 min.

### Bemerkungen zum 1. Verfahrensbeispiel:

Das Arbeiten mit einer horizontalen Durchlaufanlage führt im Vergleich zur konventionellen, vertikalen Tankanlage zu folgenden Vorzügen, die eine sichere Durchmetallisierung zum Teil erst möglich machen:
- Durch bessere Durchflutung der Bohrungen in der Horizontalanlage wird die Behandlungszeit der Verfahrensschritte 3.0 und 11.0 in etwa halbiert, die des Verfahrensschritts 5.0 sogar um das 15fache verkürzt.
- Durch die bessere Kapselung der Horinzontalanlagen wird die Verschmutzung der Arbeitsräume verhindert. Bei konventionellen Tankanlagen kommt es durch die hohe Verdunstungsrate des Pyrrols auch bei guter Absaugung zu schwarzer Polypyrrol-Bildung auf allen sauren Oberflächen.
- Durch kurze Transportzeiten (ca. 10 s) kann der Aktivator nach Verfahrensschritt 7.0 im Bohrloch nicht zusammenlaufen. Dadurch werden im Verfahrensschritt 8.0 gleichmäßige leitende Polypyrrolschichten gebildet, die im Verfahrensschritt 11.0 zu fehlerfrei metallisierten Bohrungen führen. Ein Zusammenfließen der im Verfahrensschritt 7.0 aufgebrachten Aktivator-Lösung wird auch durch die horizontal veralufenden Bohrriefen erschwert.

In konventionellen Tankanlagen fließt der Aktivator durch die längeren Transportzeiten (ca. 30 s) im unteren Bereich der Bohrhülse zusammen. Deshalb werden hier ausreichend leitende Polypyrrol-Schichten nur im unteren Teil der Bohrungen gebildet.

Das beschriebene Verfahren würde in konventionellen Tankanlagen daher nur zu mangelhaft metallisierten Bohrungen führen und wäre für die Leiterplattenherstellung nicht zu gebrauchen.

Ein Zusammenfließen der Aktivator-Lösung wird hier durch die nun vertikal verlaufenden Bohrriefen nicht erschwert.

### Beispiel 2

Eine 35 x 18 cm große Platte aus kupferkaschiertem FR-4-Epoxyd-Basismaterial wurde zugeschnitten und zum Herstellen einer Leiterplatte mit metallisierten Lochwandungen wie folgt behandelt:
1. Herstellen der Lochungen
2. 30 sec reinigen in einer wässrigen Lösung von NatriumPeroxodisulfat (120 g/l) und H₂SO₄ -(70 g/l)
3. 2 min 30 sec quellen in handelsüblicher Quellmittelösung (70° C), nachfolgend 1 min spülen in Wasser
5. 2 min, 30 sec behandeln mit wässriger alkalischer Permanganat-Lösung, enthaltend
   - KMnO₄: 60 g/l
   - NaOH: 60 g/l (70° C)
6. Kurz spülen in Wasser
7. 10 sec behandeln in wässriger Monomerlösung, enthaltend
   30 Gew.-% N-Methylpyrrolidon
   10 Gew.-% Pyrrol
   Rest Wasser
8. 10 sec behandeln in wässriger Schwefelsäure-Lösung, enthaltend
   300 g/l H₂SO₄
9. 1 min spülen in Wasser
10. 1 min dekapieren
11. 6 min 30 sec galvanisch verkupfern im handelsüblichen sauren Bad, Stromdichte 4 A/dm²
12. 1 min spülen in Wasser
13. Trocknen, Maskendruck
14. Galvanische Verkupferung der nicht von der Maske abgedeckten Bereiche in einem handelsüblichen Bad für eine Zeitspanne, die ausreicht, um die erwünschte Dicke der Kupferschicht zu erreichen.
15. Galvanisches Aufbringen einer Blei/Zinn-Schicht
16. Entfernen der Maskenschicht, Abätzen des sodann freigelegten Kupfers (und anschließend, falls erwünscht, Entfernen der Blei/Zinn-Schicht).

Die resultierende Leiterplatte war fehlerfrei und wies Lochwandverkupferungen von ausgezeichneter Qualität und Haftung auf.

### Beispiel 3

Wie Beispiel 2, jedoch mit dem zusätzlichen Verfahrensschritt des Trocknens der Platte nach der Behandlung mit Permanganat. Die getrocknete Platte zeigt sehr gute Lagerfähigkeit.

Nach Lagerung und vor der Weiterverarbeitung in der Monomerlösung wird die Platte kurz gespült. Das Resultat entsprach dem des Beispiels 2.

### Beispiel 4

Kupferkaschiertes Basismaterial wurde auf die gewünschte Größe zugeschnitten und entsprechend Beispiel 2, Schritte 1 bis 9, oder entsprechend Beispiel 3 behandelt. Anschließend wird die Platte getrocknet und wie folgt weiterverarbeitet.
A) Aufbringen einer dem Negativ des Leitungsmusters entsprechenden Maskenschicht.
b) Anätzen in H₂SO₄/Natrium-Peroxodisulfat-Lösung, spülen in Wasser, dekapieren (5 Vol.-% H₂SO₄ in Wasser).
c) Einbringen in ein saures Bad zur galvanischen Kupferabscheidung für eine Zeitspanne, die ausreicht, die Kupferschicht bis zu gewünschten Sollstärke der Leiterzüge aufzubauen.
d) Weiterverarbeiten wie bei Beispiel 1, Schritte 15 und 16

Die so herstellten Leiterplatten entsprachen allen Qualitätsanforderungen.

### Beispiel 5

Eine Platte aus kupferkaschiertem Basismaterial wurde auf die gewünschte Größe zugeschnitten, zunächst entsprechend Beispiel 2 oder 3, Schritte 1 bis 10, behandelt. Anschließend wurde die Platte in ein saures galvanisch arbeitendes Kupferbad für einen Zeitraum gebracht, der ausreicht, um die gewünschte Endschichtdicke (20 - 40 m) der Lochwandverkupferung zu erzielen. Die Weiterverarbeitung erfolgte in bekannter Weise und leiferte Leiterplatten ausgezeichneter Qualität.

### Beispiel 6

Eine 38 x 38 cm große Platte aus FR-4-Basismaterial, das anstelle der Kupferkaschierung beidseitig mit einer Haftvermittlerschicht ausgerüstet ist, wird wie folgt verarbeitet:
1. Herstellen der Lochungen
2. Wie Beispiel 2, Schritte 5 bis 9
3. Trocknen
4. Aufbringen einer dem Negativ des gewünschten Leitermusters entsprechenden Maskenschicht
5. Einbringen in ein saures, galvanisches Verkupferungsbad für eine Zeitspanne, die ausreicht, um die Leiterzüge einschließlich der Lochwandverkupferung bis zur Sollstärke aufzubauen.
6. Entfernen der Maskenschicht
7. Behandeln für 30 sec in einer wässrigen Lösung von
   - KMnO₄: 60 g/l
   - NaOH: 40 g/l (70° C)
8. Einbringen in eine Oxalsäurelösung für eine Zeit, die ausreicht, um die Oberfläche zwischen den Leiterzügen von allen Verfahrensrückständen weitgehend beziehungsweise vollständig zu befreien.

### Beispiel 7

Eine Platte aus kleberbeschichtem Basismaterial wurde wie in Beispiel 1 oder 3, Schritte 1 bis 14, behandelt. Sodann wurde die Maskenschicht entfernt und die sodann freigelegte dünne Kupferschicht abgeätzt. Daran anschließend wurde wie in Beispiel 6, Schritte 7 und 8, verfahren. Das Resultat entsprach dem des vorherigen Beispiels.

### Beispiel 8

Die Beispiele 5 und 6 wurden mit vergleichbaren Ergebnissen wiederholt, wobei jedoch von unkaschiertem Basismaterial ohne Kleberbeschichtung (harzreiche Laminatoberfläche ausgegangen wurde.

### Beispiel 9

Eine 38 x 18 cm große Platte aus FR-4-Basismaterial, die durch Verpressen von Prepregs und kupferkaschierten Innenlagenlaminaten mit dem Ziel hergestellt wird, an den Außenseiten des Laminats keine Kupferkaschierung auszuweisen und auch nicht mit einer Haftvermittlerschicht ausgerüstet ist, wobei die Außenflächen des Laminats nicht harzreich gegenüber dem Glasfaseranteil ausgeführt sein brauchen, wird wie folgt verarbeitet:
1. Herstellen der Lochungen
2. 10 min quellen in einer wässrigen Lösung, bestehend aus
   45 Vol.-% Dimethylformamid,
   20 Vol.-% Diethylenglycoldimethylether (30^{o} C)
3. 1 min spülen in Wasser (50^{o} C)
4. 10 min behandeln in einer wässrigen Lösung von Chromtrioxid 300 g/l (70^{o} C)
5. 1 min spülen in Wasser (50^{o} C)
6. 1 min spülen in Wasser
7. Reduzieren anhaftender Cr(VI)ionen-Reste in einer NaHSO₃-Lösung
8. 1 min spülen in Wasser
9. Wie Beispiel 3, Schritte 5 bis 14.

Sodann wurde die Maskenschicht entfernt und die sodann freigelegte dünne Kupferschicht abgeätzt. Daran anschließend wurde wie in Beispiel 6, Schritte 7 und 8, verfahren. Das Resultat entsprach dem des vorherigen Beispiels.

### Beispiel 10

Beispiel 2 wurde wiederholt mit dem Unterschied, daß das Verfahren nach Schritt 10 unterbrochen und die getrocknte, mit der elektrisch leitfähigen Polymerschicht versehene Basismaterialplatte vor der Weiterverarbeitung für 2 Wochen unter normalen Umweltbeindungen gelagert wurde. Zur Weiterverarbeitung wurde die Platte erneut in die Schwefelsäurelösung von Schritt 9 gebraucht, anschließend gespült und sodann, wie zuvor beschrieben, verfahren.

Versuche haben ergeben, daß sich das erfindungsgemäße Verfahren mit gleich ausgezeichneten Resultaten für die Anfertigung von Vielebenenschaltungen eignet.

## Patentansprüche

1. Verfahren zur direkten Metallisierung von Leiterplatten unter Auslassung außenstromloser Metallisierungsbäder, mit den folgenden, in einer horizontal arbeitenden Durchlaufanlage, durch geführten Schritten a-c:
a. eine multifunktionelle Adsorptionsschicht wird selektiv auf den nichtleitenden Stellen der Leiterplatte erzeugt, wobei die Adsorptionsschicht im nachfolgenden Schritt c als Oxidationsmittel dient oder ein im nachfolgenden Schritt c wirkendes Oxidationsmittel adsorbiert und/oder in ihren Poren speichert,
b. die Adsorptionsschicht wird anschließend mit zur Bildung leitfähiger Polymerer geeigneten monomeren Verbindungen behandelt, worauf innerhalb einer Transportzeit von wenigen, bis zu 10 sec die Leiterplatte zu einen nächsten Aktiv bad überführt wird
c. worin die monomeren Verbindungen anschließend unter Bildung leitfähiger Polymerer reagieren, indem die leitfähigen Polymere im sauren pH-Bereich durch die oxidierende Wirkung der Oxidationsmittel durch vollständige Umsetzung aus den monomeren Verbindungen gebildet werden, und überschüssige Reaktionsmittel oder unreagierte Anteile durch Säure entfernt werde,
d. die Leiterplatten werden in einem anschließenden Schritt galvanisch metallisiert.

2. Verfahren nach Anspruch 1, dadurch gekennzeichnet, daß zur Erzeugung der Adsorptionsschicht Permanganat als Oxidationsmittel verwendet wird, daß die auf den nichtleitenden Stellen der Leiterplatte gebildeten schwerlöslichen Manganoxide und Manganhydroxide bis zur Bildung der leitfähigen Polymere auf diesen Stellen verbleiben und in der Reaktion mit den monomeren Verbindungen als Oxidationsmittel dienen.

3. Verfahren nach Anspruch 1, dadurch gekennzeichnet, daß die nichtleitenden Stellen der Leiterplatte zur Erzeugung der Adsorptionsschicht durch Quellen oder Aufrauhen dieser Stellen unter Bildung einer mikroporösen Oberfläche so vorbereitet werden, daß sie als Speichermedium für ein Oxidationsmittel, vorzugsweise Permanganat oder Chromat/Dichromat ,dienen, und daß das Oxidationsvermögen des in der Adsorptionsschicht gespeicherten Oxidationsmittels in der darauf folgenden 1 bis 10 Sekunden andauernden Spül-, Schwall-, Saug- oder Sprühbehandlung erhalten bleibt, so daß die leitfähigen Polymere bei der sich daran anschließenden Reaktion der monomeren Verbindungen mit dem in der Adsorptionsschicht gespeicherten Oxidations mittel selektiv nur auf den nichtleitenden Stellen der Leiterplatte gebildet werden.

4. Verfahren nach einem der vorstehenden Ansprüche, dadurch gekennzeichnet, daß die Leiterplatten in einer Durchlaufanlage behandelt werden, die üblicherweise für die Bohrlochreinigung von Leiterplatten, vorzugsweise mit Permanganat, verwendet wird, und daß die Bohrlochreinigung und die direkte Metallisierung der Leiterplatten in einer Moduleinheit mit veränderbarer Vorschubgeschwindigkeit durchgeführt werden.

## Claims

1. Method of directly metallising printed circuit boards with the omission of metallising baths not provided with external current, such method having the following steps a) - c) , which are effected in a horizontally operating continuous system:
a) a multifunctional adsorption layer is selectively produced at the non-conductive locations of the printed circuit board, the adsorption layer serving as the oxidising agent in the subsequent step c) or adsorbing an oxidising agent acting in the subsequent step c) and/or storing such in its pores,
b) the adsorption layer is subsequently treated with monomeric compounds suitable for the formation of conductive polymers, whereupon the printed circuit board is transferred to an adjacent active bath within a conveying period of a few seconds, up to 10 secs.,
c) wherein the monomeric compounds subsequently react to form conductive polymers, in that the conductive polymers are formed in the acidic pH range by the oxidising effect of the oxidising agents by a complete transformation from the monomeric compounds, and excess reagents or unreacted proportions are removed by acid, and
d) the printed circuit boards are galvanically metallised in a subsequent step.

2. Method according to claim 1, characterised in that permanganate is used as the oxidising agent to produce the adsorption layer, in that the grudgingly soluble manganese oxides and manganese hydroxides, formed at the non-conductive locations of the printed circuit board, remain at these locations until the conductive polymers are formed and serve as the oxidising agents in the reaction with the monomeric compounds.

3. Method according to claim 1, characterised in that the non-conductive locations of the printed circuit board for producing the adsorption layer are prepared by swelling or roughening these locations to form a microporous surface so that they serve as the storage medium for an oxidising agent, preferably permanganate or chromate/dichromate, and in that the oxidising capacity of the oxidising agent stored in the adsorption layer is maintained in the subsequent rinsing, swelling, suction or spray treatment, which lasts between 1 and 10 seconds, so that the conductive polymers during the subsequent reaction of the monomeric compounds with the oxidising agent stored in the adsorption layer are selectively formed only at the non-conductive locations of the printed circuit board.

4. Method according to one of the preceding claims, characterised in that the printed circuit boards are treated in a continuous system, which is normally used for the cleaning of bore-holes in printed circuit boards, preferably with permanganate, and in that the cleaning of bore-holes and the direct metallisation of the printed circuit boards are effected in a modular unit having a variable advancing speed.

## Revendications

1. Procédé de métallisation directe de cartes de circuit imprimé, dans lequel les bains de métallisation sans courant externe sont supprimés et qui comprend les étapes a - c suivantes, exécutées dans une installation à passage horizontal continu :
a) une couche d'adsorption, exerçant plusieurs fonctions, est déposée de manière sélective sur les parties non conductrices de la carte de circuit imprimé, la couche d'adsorption étant utilisée dans l'étape suivante c) comme agent d'oxydation ou adsorbant dans l'étape suivante c) un agent d'oxydation et/ou le stockant dans ses pores ;
b) la couche d'adsorption est ensuite traitée avec des liaisons monomères aptes à former des polymères conducteurs, puis les cartes de circuit imprimé sont transportées en quelques secondes, 10s au maximum, vers un bain d'activation consécutif;
c) dans lequel les liaisons monomères réagissent ensuite en formant des polymères conducteurs, les polymères conducteurs étant formés à partir des liaisons monomères dans la zone à pH acide suite à une décomposition totale due à la réaction oxydante des agents d'oxydation et les agents réactionnels excédentaires ou les composés n'ayant pas réagi sont éliminés par les acides ;
d) les cartes de circuit imprimé sont métallisées dans un bain électrolytique au cours d'une étape consécutive.

2. Procédé selon la revendication 1, caractérisé en ce que l'agent d'oxydation utilisé pour produire la couche d'adsorption est un permanganate, en ce que les hydroxydes de manganèse et les oxydes de manganèse difficilement solubles, formés sur les parties non conductrices de la carte de circuit imprimé, sont maintenus sur ces parties jusqu'à la formation des polymères conducteurs et sont utilisés comme agents d'oxydation dans la réaction avec les liaisons monomères.

3. Procédé selon la revendication 1, caractérisé en ce que les parties non conductrices de la carte de circuit imprimé sont préparées pour produire la couche d'adsorption par gonflement ou par décapage de ces parties en formant une surface microporeuse, de telle sorte qu'elles servent de moyen de stockage pour les agents d'oxydation, de préférence, le permanganate ou le chromate/bichromate, et en ce que le pouvoir d'oxydation de l'agent d'oxydation stocké dans la couche d'adsorption est maintenu pendant le traitement consécutif de lavage, de projection, d'aspiration ou de pulvérisation, qui dure entre 1 et 10 secondes, de telle sorte que, pendant la réaction consécutive des liaisons monomères avec l'agent d'oxydation stocké dans la couche d'adsorption, les polymères conducteurs ne se forment de manière sélective que sur les parties non conductrices de la carte de circuit imprimé.

4. Procédé selon l'une quelconque des revendications précédentes, caractérisé en ce que les cartes de circuit imprimé sont traitées dans une installation à passage continu, qui est utilisée généralement pour le nettoyage des forures réalisées dans les cartes de circuit imprimé, de préférence avec du permanganate, et en ce que le nettoyage des forures et la métallisation directe des cartes de circuit imprimé sont exécutés dans une unité modulaire, dont on fait varier la vitesse d'avance.
